Europäisches Patentamt

European Patent Office

Office européen des brevets

(11) Numéro de publication: **0 309 365 B1**

(12) **FASCICULE DE BREVET EUROPEEN**

(45) Date de publication de fascicule du brevet: **25.11.92** (51) Int. Cl.5: **G05F 1/56**, H03M 1/00

(21) Numéro de dépôt: **88420315.9**

(22) Date de dépôt: **19.09.88**

(54) **Source de courant ajustable et convertisseur numérique/analogique à auto-calibration utilisant une telle source.**

(30) Priorité: **21.09.87 FR 8713332**

(43) Date de publication de la demande:
**29.03.89 Bulletin 89/13**

(45) Mention de la délivrance du brevet:
**25.11.92 Bulletin 92/48**

(84) Etats contractants désignés:
**DE FR GB IT NL SE**

(56) Documents cités:
**EP-A- 0 061 199**
**US-A- 3 826 970**
**US-A- 4 166 962**

**D3 = ELECTRONIC ENGINEERING; C.L.Alley et K.W.Atwood; John Wiley & Sons, Inc.; New York, USA; 1973. Section 4.4: Transistor Equivalent Circuits.**

(73) Titulaire: **SGS-THOMSON MICROELECTRONICS S.A.**
**7, Avenue Galliéni**
**F-94250 Gentilly(FR)**

(72) Inventeur: **Ramet, Serge**
**7 bis, Rue Gabriel Péri**
**F-38000 Grenoble(FR)**

(74) Mandataire: **de Beaumont, Michel et al**
**1bis, rue Champollion**
**F-38000 Grenoble(FR)**

Rank Xerox (UK) Business Services

## Description

La présente invention concerne des sources de courant ajustables avec précision par une tension et plus particulièrement l'application de telles sources de courant à la formation de convertisseurs numérique/analogique à autocalibration de haute précision, par exemple à 12 bits.

Dans l'art antérieur, pour obtenir des convertisseurs numériques/analogiques de haute précision et de grande linéarité, on utilise généralement des transistors de type bipolaire associés à des réseaux R-2R qui réalisent un ensemble de sources de courant commutables dont les valeurs rapportées à la valeur d'un courant de référence forment une progression géométrique de raison 2. Toutefois, en raison des dispersions de fabrication qui affectent la résistance des réseaux R-2R et les transistors bipolaires, il est nécessaire, dès que le nombre de bits du convertisseur numérique/analogique dépasse 7 ou 8, d'effectuer un ajustage par laser des résistances des réseaux R-2R si l'on désire obtenir une très grande linéarité. Dans l'art antérieur pour obtenir des convertisseurs numériques/analogiques de haute précision et grande linéarité, sans avoir recours à l'ajustage par laser d'un quelconque élément du convertisseur, on a proposé divers types de convertisseurs numériques/analogiques à autocalibration dont les éléments calibrables sont des condensateurs ; lesdits condensateurs appartenant à un ensemble de condensateurs dont les valeurs de capacité rapportées à la valeur de capacité d'un condensateur unitaire forment une progression géométrique de raison 2.

La document EP-A-0061199 décrit un convertisseur numérique/analogique comprenant une source de courant ajustable comprenant des transistors bipolaires reliés par leurs émetteurs par l'intermédiaire d'une résistance MOS variable. Cette connexion aux émetteurs ne permet qu'un réglage grossier du courant car le réglage de la résistance réagit sur la tension base-émetteur des transistors bipolaires. De plus, ce document prévoit une mémorisation de la tension de réglage de la résistance variable par un condensateur relié entre la grille de la résistance MOS et la masse. Ce montage est très sensible au bruit et nécessite d'utiliser pour la commande de grille un amplificateur sophistiqué de grande précision et à très faible bruit.

Un objet de la présente invention est de prévoir une source de courant simple, ajustable avec une particulièrement grande précision.

Un autre objet de la présente invention est de prévoir un convertisseur numérique/analogique réglable avec précision utilisant une source de courant ajustable et pouvant donc avoir un nombre de cellules élevé.

Un autre objet de la présente invention est de prévoir un tel convertisseur numérique/analogique particulièrement simple à fabriquer et précis dans son fonctionnement.

Ces objets, caractéristiques, avantages ainsi que d'autres de la présente invention sont atteints en prévoyant une source de courant ajustable comprenant un transistor bipolaire dont la base reçoit un signal propre à fixer approximativement le courant qui le traverse, et un transistor MOS, en série avec le transistor bipolaire, dont la grille reçoit un signal de réglage mémorisé par un condensateur connecté entre sa grille et son drain, ce drain étant connecté au collecteur du transistor bipolaire.

De préférence le transistor bipolaire est un transistor NPN et le transistor MOS un transistor à canal P à enrichissement, la source du transistor MOS étant connectée à une tension haute, son drain étant connecté au collecteur du transistor bipolaire et l'émetteur du transistor bipolaire étant connecté à une source de tension basse.

De préférence le signal de réglage provient d'un amplificateur de courant fournissant un signal d'erreur résultant de la comparaison entre ladite source de courant et une source de courant de référence.

Un convertisseur numérique/analogique selon l'invention est tel que ses étages correspondant aux bits d'ordre inférieur comprennent des sources de courant classiques et que ses étages correspondant aux bits d'ordre supérieur comprennent chacun une source de courant selon la présente invention.

Ce convertisseur numérique/analogique comprend des moyens de commutation et d'amplification pour comparer périodiquement le courant dans chacune des sources de courant correspondant aux bits d'ordre supérieur à la somme des courants des sources de courant des bits inférieurs et pour ajuster en conséquence le courant dans lesdites sources de courant correspondant aux bits d'ordre supérieur.

Ces objets, caractérisques et avantages de la présente invention seront exposés plus en détail dans la description suivante de modes de réalisation particuliers faite en relation avec les dessins joints parmi lesquels :

la figure 1 représente schématiquement une source de courant ajustable selon la présente invention ;

la figure 2 représente schématiquement un convertisseur numérique/analogique selon la présente invention ;

la figure 3 représente schématiquement une variante de connexion de la source de courant selon la présente invention dans un convertisseur numérique/analogique ;

la figure 4 illustre le procédé de calibration selon la présente invention ; et

la figure 5 représente un exemple d'amplificateur de courant à fonctionnement séquentiel utilisable lors de l'étape de calibration.

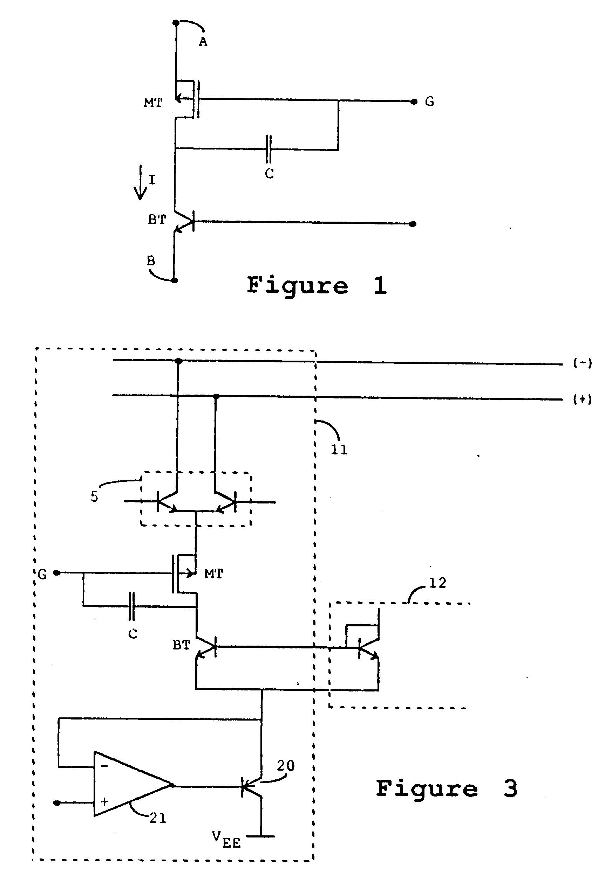

La figure 1 représente une source de courant ajustable par une tension selon l'invention. Cette source de courant est destinée à laisser passer un courant choisi I et est connectée entre une borne de tension haute A et une borne de tension basse B, par l'intermédiaire de circuits non représentés. Elle comprend essentiellement un transistor bipolaire BT en série avec un transistor MOS MT. Dans l'exemple représenté, le transistor bipolaire BT est un transistor NPN dont l'émetteur est connecté à la borne B et dont le collecteur est connecté au drain du transistor MT, un transistor à canal P à enrichissement. La source du transistor MT est connecté à la borne A. La grille du transistor MT est connectée à son drain par l'intermédiaire d'un condensateur de mémorisation C.

Normalement, une source de courant classique comprend seulement le transistor bipolaire BT dont la base reçoit une tension de polarisation appropriée, en fonction des valeurs des tensions haute et basse pour fixer le courant dans le transistor bipolaire. En fait, en raison des dispersions de fabrication, on n'arrive jamais exactement à la valeur de courant souhaitée.

Selon l'invention, le transistor MOS MT disposé en série avec le transistor bipolaire BT permet d'effectuer un réglage fin en modifiant légèrement la tension collecteur/émetteur du transistor bipolaire BT. Ce réglage est effectué par action sur la grille G du transistor MOS. On notera que l'influence du réglage est d'autant plus nette que l'impédance entre l'émetteur du transistor BT et la borne de tension basse B est faible. En outre, selon l'invention, il est prévu de mémoriser la tension de grille appliquée sur le transistor MOS au moyen du condensateur C. Ainsi, il est possible d'agir périodiquement seulement sur la grille du transistor MT, la valeur de réglage restant mémorisée sur le condensateur C en dehors des périodes de calibration.

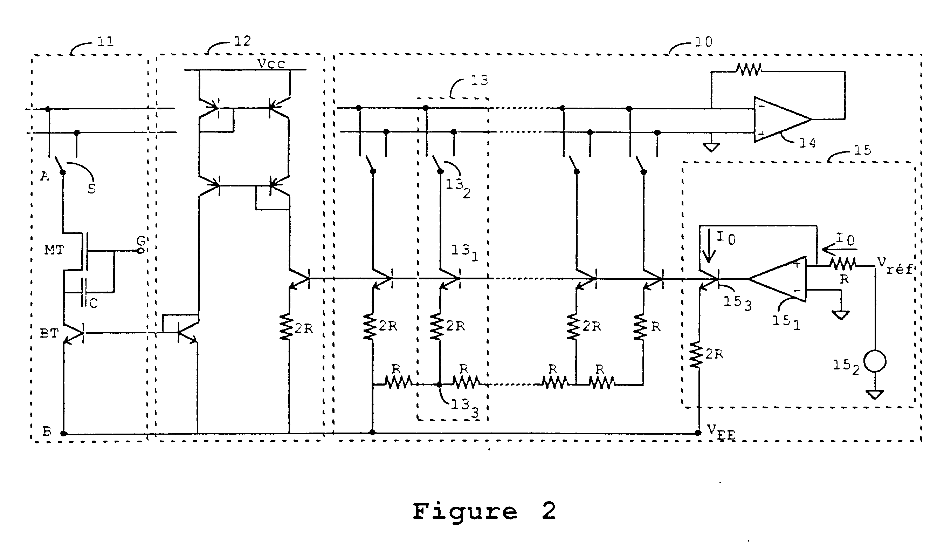

La figure 2 représente un mode de réalisation d'un convertisseur numérique/analogique selon la présente invention. Dans cette figure, le bloc 10 représente un convertisseur numérique/ analogique classique, le bloc 11 représente un étage supplémentaire de convertisseur selon la présente invention et le bloc 12 représente un exemple d'étage de polarisation pour le bloc 11.

Une cellule de convertisseur numérique/analogique classique 10 est représentée dans un bloc 13. Cette cellule comprend un transistor bipolaire $13_1$ dont le collecteur est relié par un interrupteur $13_2$ à l'entrée plus (+) ou à l'entrée moins (-) d'un amplificateur différentiel 14. L'émetteur du transistor $13_1$ est reliée à un point de connexion $13_3$ par une résistance 2R et ce point de connexion est relié aux résistances 2R des cellules adjacentes par des résistances de valeur R. Dans chaque cellule, le transistor $13_1$ a une surface d'émetteur correspondant à l'ordre du bit converti par cette cellule et l'interrupteur $13_2$ est connecté à l'entrée (-) ou à l'entrée (+) de l'amplificateur 14 selon que le bit en question a une valeur binaire "1" ou "0". La base du transistor $13_1$ est polarisée par un circuit 15 comprenant un amplificateur différentiel $15_1$ dont une première entrée (-) est reliée à la masse et dont la deuxième entrée (+) est reliée à une source de tension de référence $15_2$ par l'intermédiaire d'une résistance R. Cette deuxième entrée (+) de l'amplificateur différentiel $15_1$ est reliée au collecteur d'un transistor bipolaire $15_3$ dont l'émetteur est relié à une tension d'alimentation basse VEE par l'intermédiaire d'une résistance 2R et dont la base est reliée à la sortie de l'amplificateur $15_1$. On fixe ainsi le courant I0 passant dans le transistor $15_3$ et donc son potentiel de base. Ce potentiel de base est appliqué aux bases de tous les transistors $13_1$ qui laisseront donc passer des courants proportionnels au courant I0, selon le poids du bit de la cellule correspondante. Dans ce bloc 10, les deux premières cellules sont des cellules à transistors identiques qui laissent passer le courant correspondant au bit de poids le plus faible. On notera que la première de ces deux premières cellules comprend une résistance de valeur R et non 2R en série avec son transistor.

Le bloc 11 désigne la cellule du convertisseur numérique/analogique correspondant au bit d'ordre immédiatement supérieur à la dernière cellule du bloc 10, par exemple au huitième bit si le convertisseur numérique/analogique du bloc 10 est un convertisseur à sept bits. Un seul bloc 11 a été représenté, mais on concevra que pour réaliser un convertisseur à grand nombre de bits, plusieurs cellules analogues à celles du bloc 11 seront utilisées. Dans ce bloc 11, retrouve le transistor bipolaire BT, le transistor MOS MT et le condensateur C de la figure 1. La borne B de la figure 1 est reliée à la tension d'alimentation VEE et la borne A de la figure 1 est reliée à un commutateur S permettant de connecter la cellule selon l'invention à l'une ou l'autre des entrées de l'amplificateur différentiel de sortie 14.

On a également représenté en figure 2, dans le bloc 12, un circuit de polarisation de la base du transistor bipolaire BT. Comme on le verra sur la figure, ce circuit comprend essentiellement des miroirs de courant et est destiné à polariser le transistor BT de telle sorte que son courant de collecteur ait une valeur aussi voisine que possible du double de la valeur du courant correspondant au bit de poids le plus fort du bloc 10. Ce circuit 12 permet de s'affranchir du fait qu'il n'y a pas de résistance 2R en série entre l'émetteur du transistor bipolaire BT et la tension basse VEE.

On notera que le convertisseur de la figure 2 est uniquement destiné à faire comprendre la présente invention et à expliquer une technique de conversion compatible avec l'utilisation de cellules selon la présente invention. Il conviendra de garder à l'esprit que le schéma réel d'un convertisseur fait appel à des techniques de circuiterie plus complexes qui ne seront pas exposées ici par souci de simplicité de la description.

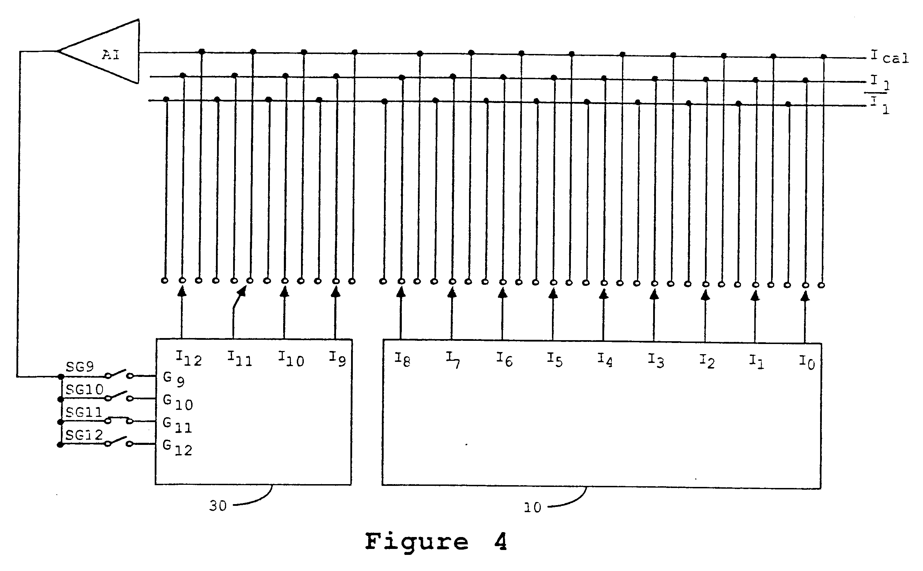

La figure 3 représente uniquement à titre d'exemple une réalisation possible plus détaillée d'une cellule 11 selon l'invention. On retrouve dans cette figure 3 le transistor MOS MT et sa borne de grille G, le condensateur C et le transistor BT. Le transistor BT est connecté en miroir de courant avec un transistor non référencé faisant partie du bloc 12 de la figure 2. De façon classique, le commutateur S est réalisé au moyen d'une paire de transistors NPN dont les bases reçoivent le signal correspondant à la valeur du bit de la cellule 11 et son signal complémentaire.

Dans cette figure 3, la caractéristique principale est que l'émetteur du transistor BT au lieu d'être relié directement à la tension basse VEE est relié à cette source de tension par l'intermédiaire d'un transistor bipolaire PNP vertical 20 dont l'émetteur est connecté à l'émetteur du transistor BT et dont le collecteur est relié à la tension basse VEE. La tension sur l'émetteur de ce transistor est fixée par un asservissement comprenant un amplificateur 21 dont une première entrée ( + ) reçoit une tension de référence, dont la deuxième entrée (-) est reliée à l'émetteur du transistor 20 et dont la sortie est reliée à la base de ce transistor. Ce montage permet de s'affranchir des fluctuations éventuelles de la tension basse VEE. Ceci ne constitue qu'un exemple des divers perfectionnements qui peuvent être apportés au dispositif.

La figure 4 représente un exemple de réalisation du procédé de calibrage selon l'invention. On retrouve dans cette figure 4 le bloc 10 de la figure 2 correspondant à un convertisseur numérique/analogique délivrant des courants I0 à I8, le courant I0 etant égal au courant I1, le courant I1 correspondant au bit de moins significatif et le courant I8 au bit le plus significatif. Ainsi, chacune des cellules peut être connectée à une entrée $I_{CAL}$ d'un amplificateur différentiel de courant à fonctionnement séquentiel AI.

Le bloc 30 contient des cellules du type de la cellule 11 de la figure 2. On a représenté quatre cellules fournissant des courants I9 à I12 correspondant aux quatre bits les plus significatifs à convertir. Ce bloc comprend également des entrées G9 à G12 correspondant aux grilles des transistors MOS des cellules respectives fournissant les courants I9 à I12. Dans la figure, les connexions sont indiquées comme correspondant au calibrage de la cellule fournissant le courant I11. La sortie de l'amplificateur AI est connectée par un commutateur SG11 à la grille G11 du transistor MOS qui permet le calibrage du courant I11.

Dans une première phase (non représentée), les courants I0 à I10 sont appliqués à l'entrée $I_{CAL}$ et la valeur correspondante est mémorisée par l'amplificateur AI. Dans une deuxième phase, correspondant aux connexions de la figure 4, le courant I11 est relié à l'entrée de l'amplificateur AI et comparé à la valeur mémorisée. Le signal d'erreur en sortie de l'amplificateur AI est appliqué sur la grille G11 pour ramener le courant I11 à une valeur égale à la somme des courants I0 à I10.

La précision de l'asservissement ne dépend alors que du gain de l'amplificateur AI et des éventuelles erreurs de décalage de zéro de cet amplificateur.

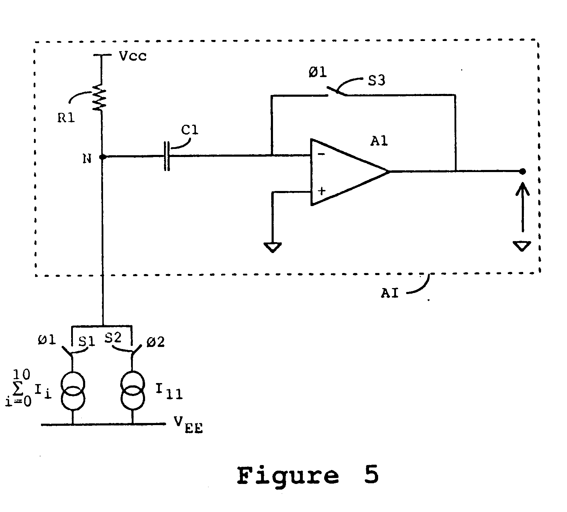

Un exemple de circuit d'amplificateur-comparateur de courant à fonctionnement séquentiel est illustré en figure 5. L'amplificateur AI lui-même comprend un amplificateur différentiel A1 dont la première entrée ( + ) est connectée à la masse, dont la deuxième entrée (-) est connectée à un noeud N par l'intermédiaire d'un condensateur C1 et dont l'entrée est connectée à la sortie par l'intermédiaire d'un interrupteur S3. Le noeud N est relié à la source d'alimentation positive VCC par l'intermédiaire d'une résistance R1 et peut être connecté par des interrupteurs S1 et S2 à l'une ou l'autre des sources de courant $I_{REF}$ ($I_{REF}$ étant égal à la somme des courants $I_0$ à $I_{10}$) et $I_{11}$, dans l'exemple représenté, par des commutateurs S1 et S2. Les commutateurs S1 et S3 sont fermés simultanément dans une première phase $\phi 1$ et le commutateur S2 est fermé dans une deuxième phase $\phi 2$ durant laquelle les commutateurs S1 et S3 sont ouverts.

Ainsi, au cours de la phase $\phi 1$, le condensateur C1 se charge à la tension VCC - R1$I_{REF}$ - $V_{os}$, $V_{os}$ étant la tension de décalage de zéro de l'amplificateur A1. En conséquence, lors de la deuxième phase $\phi 2$, on obtient en sortie de l'amplificateur A1 un signal correspondant à R1($I_{11}$ - $I_{REF}$) avec une compensation de la tension de décalage de zéro.

**Revendications**

1. Source de courant ajustable comprenant un transistor bipolaire (BT) dont la base reçoit un signal propre à fixer approximativement le courant qui le traverse, et un transistor MOS (MT) en série avec le transistor bipolaire, dont la grille (G) reçoit un signal de réglage mémorisé par un condensateur (C), caractérisé en ce que le condensateur est connecté entre la grille et le drain du transistor MOS, ce drain étant connecté au collecteur du transistor bipolaire.

2. Source de courant ajustable selon la revendication 1, caractérisé en ce que le transistor bipolaire est un transistor NPN et le transistor MOS un transistor à canal P à enrichissement, la source du transistor MOS étant connectée à une tension haute, son drain étant connecté au collecteur du transistor bipolaire et l'émetteur du transistor bipolaire étant connecté à une source de tension basse.

3. Source de courant ajustable selon l'une des revendications 1 ou 2, caractérisé en ce que le signal de réglage provient de l'amplificateur de courant fournissant un signal d'erreur résultant de la comparaison entre ladite source de courant et une source de courant de référence.

4. Convertisseur numérique/analogique, caractérisé en ce que ses étages correspondant aux bits d'ordre inférieur comprennent des sources de courant classiques et en ce que ses étages correspondant aux bits d'ordre supérieur comprennent chacun une source de courant selon l'une quelconque des revendications 1 à 3.

5. Convertisseur numérique/analogique selon la revendication 4, caractérisé en ce qu'il comprend des moyens de commutation et d'amplification pour comparer périodiquement le courant dans chacune des sources de courant correspondant aux bits d'ordre supérieur à la somme des courants des sources de courant des bits inférieurs et pour ajuster en conséquence le courant dans lesdites sources de courant correspondant aux bits d'ordre supérieur.

## Claims

1. An adjustable current source comprising a bipolar transistor (BT), the base of which receives a signal adapted to approximately set the current which flows therethrough, and a MOS transistor (MT), in series with the bipolar transistor, the gate (G) of which receives an adjustment signal stored by a capacitor (C) characterized in that said capacitor is connected between gate and drain of said MOS transistor, said drain being connected to the collector of the bipolar tansistor.

2. An adjustable current source according to claims 1, characterized in that the bipolar transistor is an NPN transistor and the MOS transistor is an enhanced P-channel transistor, the source of the MOS transistor being connected with a high voltage, its drain being connected with the collector of the bipolar transistor and the emitter of the bipolar transistor being connected with a low voltage source.

3. An adjustable current source according to claim 1 or 2, characterized in that the adjustment signal originates from the current amplifier supplying an error signal resulting from the comparison between said current source and a reference current source.

4. A digital/analog converter, characterized in that its stages corresponding to the lower rank bits comprise conventional current source and each of its stages corresponding to the higher rank bits comprises a current source according to any of claims 1 to 3.

5. A digital/analog converter according to claim 4, characterized in that it comprises switching and amplifying means for periodically comparing the current in each of the current sources corresponding to the higher rank bits with the sum of the currents of the lower rank bits current sources and for accordingly adjusting the current in said current sources corresponding to the higher rank bits.

## Patentansprüche

1. Einstellbare Stromquelle mit einem bipolaren Transistor (BT), dessen Basis ein Signal empfängt, das den durch diesen fließenden Strom näherungsweise einstellen kann, und einem mit dem bipolaren Transistor in Reihe geschalteten MOS-Transistor (MT), dessen Gate (G) ein von einem Kondensator (C) gespeichertes Stellsignal empfängt, dadurch **gekennzeichnet,** daß der Kondensator zwischen dem Gate und dem Drain des MOS-Transistors angeschlossen ist, und der Drain mit dem Kollektor des bipolaren Transistors verbunden ist.

2. Einstellbare Stromquelle nach Anspruch 1, dadurch **gekennzeichnet,** daß der bipolare Transistor ein NPN-Transistor und der MOS-Transistor ein angereicherter P-Kanal-Transistor ist, wobei die Source des MOS-Transistors mit einer Hochspannung verbunden ist, sein Drain mit dem Kollektor des bipolaren Transistors verbunden ist, und der Emitter des bipolaren Transistors mit einer Niederspannungsquelle verbunden ist.

3. Einstellbare Stromquelle nach Anspruch 1 oder 2, dadurch **gekennzeichnet,** daß das Stellsignal von einem Stromverstärker kommt, der ein sich aus dem Vergleich zwischen der Stromquelle und einer Bezugs-Stromquelle ergebendes Fehlersignal liefert.

4. Digital/Analog-Umsetzer, dadurch **gekennzeichnet,** daß seine den niederwertigen Bits entsprechenden Stufen herkömmliche Stromquellen aufweisen und seine den höherwertigen Bits entsprechenden Stufen jeweils eine Stromquelle nach einem der Ansprüche 1 bis 3 aufweisen.

5. Digital/Analog-Umsetzer nach Anspruch 4, **gekennzeichnet** durch eine Schalt- und Verstärkungs-Vorrichtung zum periodischen Vergleichen des Stromes in jeder der den höherwertigen Bits entsprechenden Stromquellen mit der Summe der Ströme der den niederwertigen Bits entsprechenden Stromquellen und zum entsprechenden Einstellen des Stromes in diesen den höherwertigen Bits entsprechenden Stromquellen.

Figure 1

Figure 3

Figure 2

EP 0 309 365 B1

Figure 4

**Figure 5**